# EUROPEAN PATENT APPLICATION

(11) **EP 3 279 765 A1**
(43) Date of publication of application: **07.02.2018**
(21) Application number: 15887550.0
(22) Date of filing: 30.03.2015
(51) Int. Cl.: G06F 1/20, H01L 23/473, H05K 7/20

(54) **ELECTRONIC-DEVICE COOLING SYSTEM**

(71) Applicant: Exascaler Inc., Tokyo 101-0052 (JP)
(72) Inventor: SAITO, Motoaki, Tokyo 101-0062 (JP)
(74) Representative: Goddar, Heinz J.
(86) International application number: PCT/JP2015/060032
(87) International publication number: WO 2016/157397

(57) **Abstract**

Provided is a cooling system improved in cooling performance of an electronic device and being simple and efficient. The cooling system 10 has a cooling tank 12, and the cooling tank 12 contains in its open space a first cooling liquid 13 having a boiling point T₁. An electronic device 100 mounting processors 110, 112 on a board 120 is stored within the open space of the cooling tank 12 and is immersed in the first cooling liquid 13. A first heat exchanger 22 is immersed in a surface layer portion of the first cooling liquid in the cooling tank 12. The first heat exchanger 22 encloses therein a second refrigerant having a boiling point T₂ (provided T₁ = T₂ or T₁ > T₂).

## Description

### Technical Field

The present invention relates to an electronic device cooling system and particularly, to an electronic device cooling system for efficiently cooling electronic devices such as super computers, data centers and the like that require ultra-high performance operations and stable operations and that have large amounts of heat generated from themselves.

### Background Art

One of the biggest problems that determine the limitation in performance of supercomputers in recent years is power consumption, and the importance of researches relating to the power-saving capability of supercomputers has already been recognized widely. That is, the speed performance per consumed power (Flops/W) has become one barometer for evaluating the supercomputers. Further, in data centers, it is understood that 45 % or so of the power consumption by the whole data centers are consumed for cooling, and therefore, a demand for reduction of the power consumption through improvements in cooling efficiency has become strong.

Heretofore, an air-cooling type and a liquid-cooling type have been in use for cooling supercomputers and data centers. The liquid-cooling type is generally recognized to be high in cooling efficiency because of using a liquid that is remarkably superior to air in heat transfer performance. For example, the "TSUBAME-KFC" built by Tokyo Institute of Technology achieved 4. 50G Flops/W by a liquid immersion cooling system using a synthetic oil and acquired the first place in "Supercomputer Green 500 List" announced on November, 2013 and June, 2014. However, because the synthetic oil being high in viscosity is used as the cooling liquid, it is difficult to completely remove, from electronic devices taken out from oil-immersed racks, the oil adhered thereto, and this gives rise to a problem that the maintenance (specifically, adjustment, inspection, repair, replacement and expansion, for example; the same applies hereafter) of the electronic devices is extremely difficult. Furthermore, the occurrence of a problem has also been reported that causes a difficulty to arise in practical use because the synthetic oil in use leaks by corroding a gasket and the like constituting the cooling system in a short period of time.

On the other hand, there has been proposed a liquid immersion cooling system that uses not the synthetic oil causing the aforementioned problems but a cooling liquid of fluorocarbon-base. Specifically, it is an example that uses a cooling liquid of the fluorocarbon-base (a hydrofluoroether (HFE) compound known as "Novec (trademark of 3M Company; the same applies hereafter) 7100", "Novec 7200" and "Novec 7300", brand names of 3M Company) (Patent Literature 1 and Patent Literature 2, for example).

### Citation List

### Patent Literature

| | |
|---|---|
| Patent Literature 1: | Japanese Patent Application Laid-Open No. 2013-187251 |
| Patent Literature 2: | Japanese Unexamined Patent Application Publication (Translation of PCT Application) No. 2012-527109 |

### Summary of Invention

### Technical Problem

The cooling system disclosed in Patent Literature 1 uses a fluorocarbon-base cooling liquid of being 100 °C or lower in boiling point because of utilizing vaporization heat (latent heat) for the cooling of electronic devices. Then, by utilizing the vaporization heat (latent heat) when the cooling liquid is vaporized by the heat generation on elements mounted on the electronic device, the system deprives the elements of heat to cool the elements. Therefore, because it may occur that on the surfaces of the elements being high in temperature, the fluorocarbon-base cooling liquid locally boils to make the resultant bubbles form thermal insulation films, there arises a problem in that the high heat conduction capability possessed inherently by the cooling liquid is spoiled. Further, electronic devices used in recent supercomputers, data centers and the like include a plurality of objects to be cooled such as a GPU (Graphics Processing Unit), a high speed memory, a chip set, a network unit, a PCI Express bus, a bus switching unit, an SSD (Solid State Drive), power units (an ac-dc converter, a dc-dc voltage converter, etc.) and the like in addition to a CPU (Central Processing Unit) . Thus, it is difficult to equally cool all of these objects which differ in vaporization temperature, so that cooling efficiency becomes very low on the objects in which refrigerant on the surfaces does not vaporize.

Further, the cooling system disclosed in Patent Literature 2 takes the configuration of a sealed module containing one or more heating electronic devices. Thus, because a mechanism for making a cooling liquid flow to pass through individual sealed modules becomes complicated as a whole and because it is unable to easily take the whole of electronic devices out from the sealed module, there arises a problem in that the maintainability of the electronic devices is inferior.

As aforementioned, the liquid immersion cooling device in the prior art involves a problem that the entire mechanism for enabling cooling liquid to flow through the sealed module becomes complicated and is inferior in the maintainability of the electronic devices.

Accordingly, an object of the present invention is to provide a cooling system capable of solving the problems of the foregoing prior art, of improving the cooling performance of an electronic device and of being simple and efficient.

### Solution to Problem

In order to solve the foregoing problems, according to one aspect of the present invention, there is provided a cooling system for directly cooling an electronic device through immersion in a cooling liquid, and the cooling system comprises a cooling tank having an open space defined by a bottom wall and side walls and containing a first cooling liquid having a boiling point T₁, wherein at least one electronic device having at least one heating element is immersed in the first cooling liquid to be cooled directly, and a heat exchanger enclosing a second refrigerant having a boiling point T₂ (T₂ = T₁ or T₂ < T₁) being the same as the boiling point T₁ of the first cooling liquid or being lower than the boiling point T₁ of the first cooling liquid and immersed in a surface layer portion of the first cooling liquid in the cooling tank.

In a preferred embodiment of the cooling system according to the present invention, a configuration may be taken that the first cooling liquid includes perfluoride as a main component and that the weight reduction percentage of the liquid after a lapse of 100 hours is 1.5 % or less when the liquid of 10 milliliter is contained in a 10-milliliter graduated cylinder (opening diameter 11.5 mm) to be subjected to spontaneous evaporation under an ordinary environment at the room temperature of 25 °C.

In the preferred embodiment of the cooling system according to the present invention, a configuration may be taken that the vapor pressure of the first cooling liquid at the room temperature of 25 °C is 1.0kPa or under.

Further, in the preferred embodiment of the cooling system according to the present invention, a configuration may be taken that the boiling point of the first cooling liquid is 150 °C or higher and that the boiling point of the second refrigerant is 50 °C or lower.

Furthermore, in the preferred embodiment of the cooling system according to the present invention, a configuration may be taken that the second refrigerant includes a fluorocarbon compound as a main component.

Furthermore, in the preferred embodiment of the cooling system according to the present invention, the cooling system may further comprise a second heat exchanger disposed outside the cooling tank for cooling the second refrigerant, and the first heat exchanger and the second heat exchanger may be connected through a first flow passage.

Further, in the preferred embodiment of the cooling system according to the present invention, the cooling tank may have a top board attached to an upper opening of the cooling tank to be detachable or to be openable and closable, and the top board may hold the first heat exchanger.

Furthermore, in the preferred embodiment of the cooling system according to the present invention, the cooling tank may have an inlet and an outlet for the first cooling liquid, the inlet and the outlet may be connected through a second flow passage being outside the cooling tank, and the flow passage may be provided with at least one pump for moving the first cooling liquid and a third heat exchanger for cooling the first cooling liquid.

Additionally, according to another aspect of the present invention, there is provide a cooling system for directly cooling a plurality of electronic devices through immersion in a cooling liquid, and the system comprises a cooling tank having an open space defined by a bottom wall and side walls and containing a first cooling liquid having a boiling point T₁, a plurality of arrayed storage sections defined by a plurality of inner partitioning walls provided within the cooling tank to divide the open space, the storage sections being for storing at least one electronic device in each storage section, and an inflow opening and an outflow opening for the first cooling liquid that are formed at each of the plurality of storage sections, wherein the inflow opening is formed at a bottom portion or a lateral surface of each storage section and wherein the outflow opening is formed in the vicinity of a liquid level of the cooling liquid flowing through each storage section. The cooling system further comprises a first heat exchanger enclosing a second refrigerant having a boiling point T₂ (T₂ = T₁ or T₂ < T₁) being the same as the boiling point T₁ of the first cooling liquid or being lower than the boiling point T₁ of the first cooling liquid, and the first heat exchanger is immersed in a surface layer portion of the first cooling liquid within each storage section.

### Advantageous Effects of Invention

According to the cooling system in the present invention, the first cooling liquid containing the first cooling liquid having the boiling point T₁ effectively and powerfully cools a main heat source such as a processor or the like and peripheral electronic components mounted on the electronic device immersed therein. Further, because of being immersed in the surface layer portion of the first cooling liquid in the cooling tank, the first heat exchanger enclosing the second refrigerant having the boiling point T₂ (T₂ = T₁ or T₂ < T₁) being the same as the boiling point T₁ of the first cooling liquid or being lower than the boiling point T₁ of the first cooling liquid takes heat away from the surface layer portion of the first cooling liquid to take the heat outside the cooling tank. In this way, a double cooling is carried out which includes the liquid immerse cooling of the whole of the main heating element and the peripheral electronic components by the first cooling liquid within the cooling tank having the open space and the deprivation of heat from the surface layer portion of the liquid immerse refrigerant (the first cooling liquid) by the first heat exchanger and thus, it is possible to improve the performance in cooling the electronic device. Further, since a cooling liquid being relatively high in boiling point can be used as the first cooling liquid, the first cooling liquid is hard to vaporize, and thus, the cooling tank containing the first cooling liquid suffices to be of the open space being non-airtight, so that it is unnecessary to take a sealed structure being complicated and expensive. In addition, since nothing is required but to immerse the first heat exchanger in the surface layer portion of the first cooling liq1uid, the volume occupied by construction components within the cooling tank is sufficient to be small. Accordingly, it can be realized to simplify and downsize the cooling system.

Incidentally, the cooling tank having the "open space" in the present description is to be construed also to encompass a cooling tank having a simple sealed structure of the degree that does not spoil the maintainability of the electronic device. For example, a structure in which the top board is attached through a gasket and the like to be detachable or to be openable and closable can be regarded as the simple sealed structure. Particularly, since the first heat exchanger suffices to be immersed in the surface layer portion of the first cooling liquid, it is possible to make the first heat exchanger held mechanically on the top board.

The foregoing object and advantages and other objects and advantages of the present invention will be further clarified by the description of the following embodiments. However, the embodiments described hereafter are for exemplification purpose and do not intend to limit the present invention to the embodiments.

### Brief Description of Drawings

[FIG. 1] FIG. 1 is a partly-enlarged, longitudinal sectional view showing the structure of an important portion in a cooling system according to one embodiment of the present invention.
[FIG. 2] FIG. 2 is a graph showing a result obtained by measuring the weight reduction percentages of various cooling liquids.
[FIG. 3] FIG. 3 is a comparison table in property of some of perfluoride.
[FIG. 4] FIG. 4 is a schematic view of a cooling system according to the one embodiment of the present invention.
[FIG. 5] FIG. 5 is a perspective view partly in section showing the structure of a high-density cooling system according to the other embodiment of the present invention.
[FIG. 6] FIG. 6 is a perspective view showing an important portion in the high-density cooling system according to the other embodiment of the present invention.
[FIG. 7] FIG. 7 is a schematic view showing an installation example of first heat exchangers in the high-density cooling system according to the other embodiment of the present invention.

### Description of Embodiments

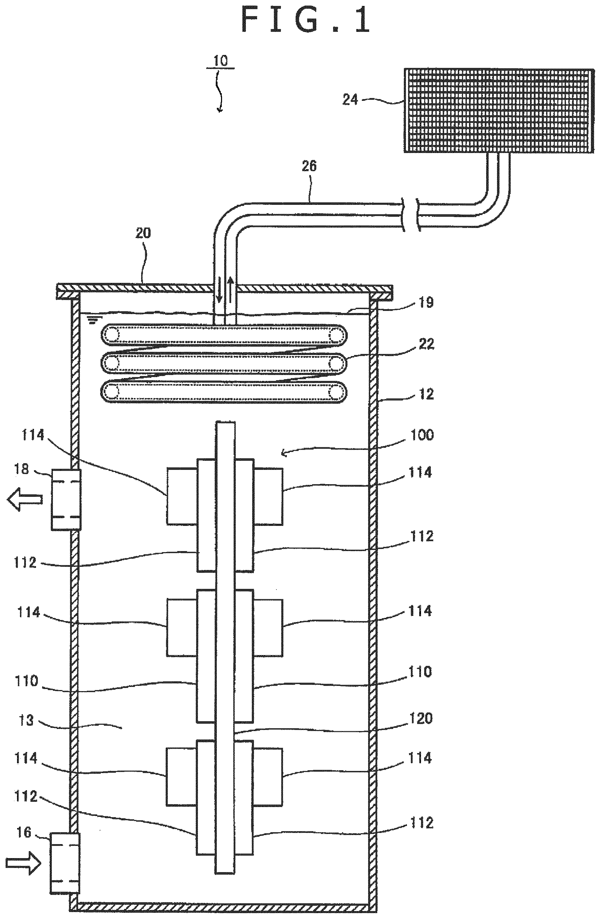

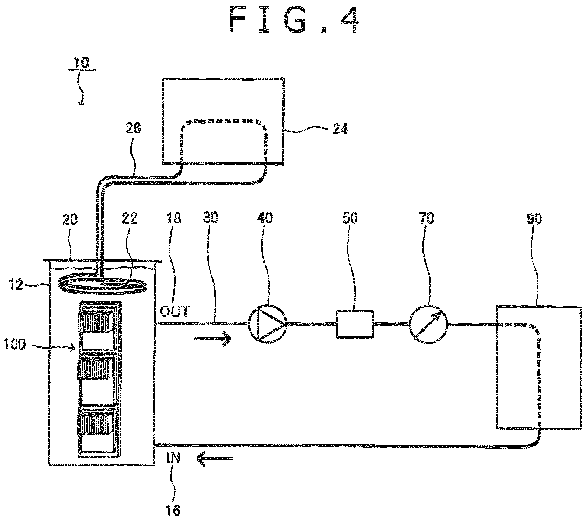

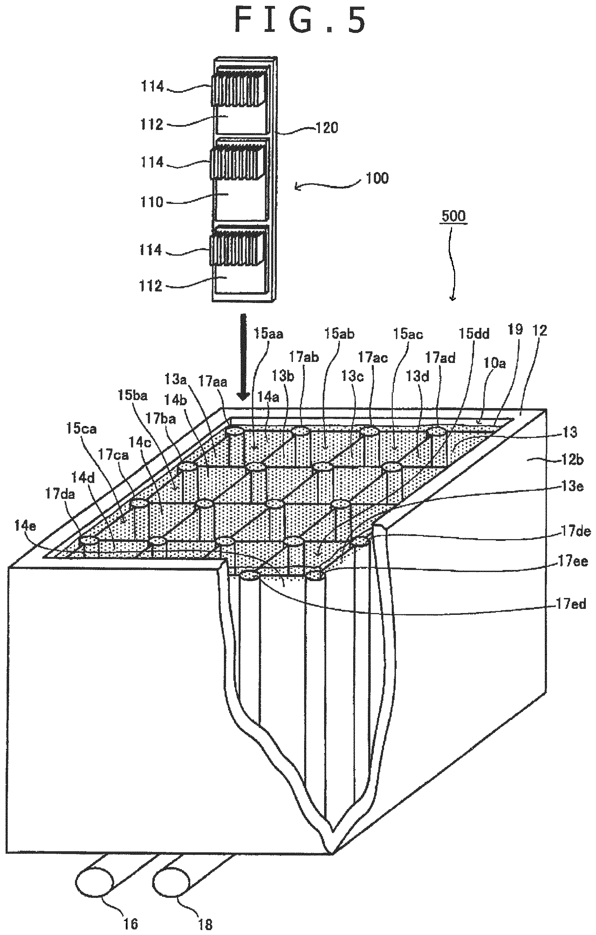

Hereinafter, preferred embodiments of a cooling system according to the present invention will be described in detail with reference to the drawings. In the description of the present embodiments, first of all, with reference to FIG. 1 to FIG. 3, there will be described as one preferred embodiment a structure of an important portion of a cooling system in which an electronic device of the configuration arranging three processor boards, each mounting a processor comprising a CPU or a GPU, on one surface of a board is housed in a cooling tank to be cooled. Then, with reference to FIG. 4, one unit only of the electronic device of the same configuration is shown schematically, and description will be made regarding the whole structure of the cooling system for cooling the electronic device with the same stored in the cooling tank. Subsequently, as the other preferred embodiment, with reference to FIG. 5 to FIG. 7, the structure of a high-density cooling system will be described which cools an electronic device stored in each of a plurality of storage sections defined in a cooling tank. Incidentally, these are for the purpose of exemplifications. The number and the kind of the processors (CPU or GPU) per board are discretionary, the number of units of the electronic devices in the cooling system is also discretionary, and such number or kind does not limit the configuration of the electronic device in the present invention.

Referring to FIG. 1, a cooling system 10 according to one embodiment of the present invention has a cooling tank 12, and the cooling tank 12 contains in an open space a first cooling liquid 13 having a boiling point T₁. In the open space of the cooling tank 12, an electronic device 100 mounting three processor boards in total on each of one surface and the other surface of a board 120 is housed and is immersed in the first cooling liquid 13, the three processor boards including one processor board 110 with a CPU mounted thereon and two processor boards 112 each with a GPU mounted thereon. The processor boards 110, 112 each include a heat radiating member (radiating fin) 114 thermally connected to the processor thereon. On the processor boards 110, 112 as well as on the board 120 for the electronic device 100, peripheral electronic components are mounted as a matter of course besides the processor, but these electronic components are omitted from illustration.

In the cooling tank 12, the first cooling liquid 13 of the quantity sufficient to immerse the whole of the electronic device 100 is contained up to a liquid level 19. It is important that the liquid level 19 of the first cooling liquid 13 is maintained to immerse all of the CPUs, each being a main heating element, and the peripheral electronic components of the electronic device 100 in the first cooling liquid 13. As described later, according to the one preferred embodiment, the first cooling liquid 13 possesses a property being extremely hard to vaporize, so that the liquid level 19 can be maintained for a long period of time. As a second cooling liquid, there can preferably be used a fluorine-based inert liquid comprising perfluoride (a perfluorocarbon compound) and known as "Fluorinert (trademark of 3M Company; the same applies hereafter) FC-72" (boiling point: 56 °C), "Fluorinert FC-770" (boiling point: 95 °C), "Fluorinert FC-3283" (boiling point: 128 °C), "Fluorinert FC-40" (boiling point: 155 °C) or "Fluorinert FC-43" (boiling point: 174 °C), the brand names of 3M Company. Although of these, "Fluorinert FC-40" or "Fluorinert FC-43" can be used particularly preferably, the use is not limited to any of these. However, according to the present invention, as the first cooling liquid 13, it is important to choose a refrigerant having a boiling point T₁ which is the same as the boiling point T₂ of a second refrigerant enclosed in a first heat exchanger referred to later or higher than the boiling point T₂ of the second refrigerant. As one example, where of hydrofluoroether (HFE) compounds known as a brand name "Novec (trademark of 3M Company; the same applies hereafter)" of 3M Company, "Novec 7000" (boiling point: 34 °C) or "Novec 7100" (boiling point: 61 °C) is used as the second refrigerant, it is possible to preferably use "Fluorinert FC-43" (boiling point: 174 °C) as the first cooling liquid 13.

Paying attention to the point that perfluoride possesses excellent properties such as ozone depletion potential being zero and the like because of being a compound which is high in electric insulation and in heat transmission capability, is inert and high in thermal and chemical stabilities, is incombustible and does not include oxygen, the present inventor completed an invention of a cooling system in which a cooling liquid including such perfluoride as a main component is used as a refrigerant for immerse cooling of high-density electronic devices, and already filed a patent application (Japanese Patent Application No. 2014-170616). In one preferred embodiment, where 10 milliliter of the first cooling liquid including such perfluoride as a main component is contained in a 10-milliliter graduated cylinder (opening diameter 11.5 mm) and is subjected to spontaneous evaporation under an ordinary environment at the room temperature of 25 °C, and where the weight reduction percentage of the liquid after a lapse of 100 hours is 1.5 % or less, the first cooling liquid 13 is hard to vaporize even in the case that the cooling tank 12 is of the open space being non-airtight. Accordingly, the loss of the first cooling liquid 13 due to vaporization can be reduced greatly. Further, in the one preferred embodiment, where the vapor pressure of the first cooling liquid 13 at the room temperature of 25 °C is 1.0kPa or under, where the boiling point of the first cooling liquid 13 is 150 °C or higher, or where perfluoride contained as a main component is a perfluoride being 10 or higher in carbon number, the first cooling liquid 13 is likewise hard to vaporize even in the case that the cooling tank 12 is of the open space being non-airtight, so that the loss of the first cooling liquid due to vaporization can be reduced greatly.

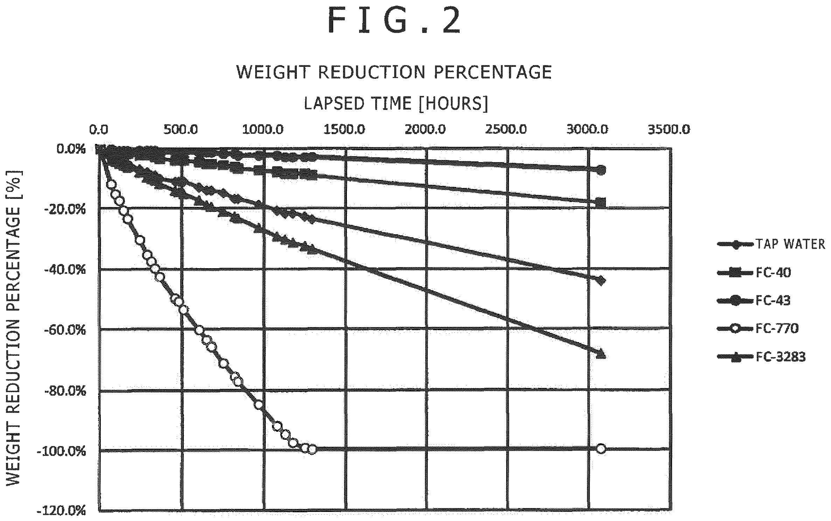

FIG. 2 shown a relation of liquid weight reduction percentage to time with respect to four kinds of perfluoride known as "Fluorinert", a brand name of 3M Company, and tap water where each liquid of 10 milliliter is contained in a 10-milliiter graduated cylinder (opening diameter 11.5 mm) and is subjected to spontaneous evaporation under an ordinary environment at the room temperature of 25 °C.

As clear from the inclinations of the weight reduction percentage, it can be grasped that FC-40 is remarkably hard to vaporize in comparison with tap water. Further, it can be grasped that FC-43 is further remarkably harder to vaporize than FC-40.

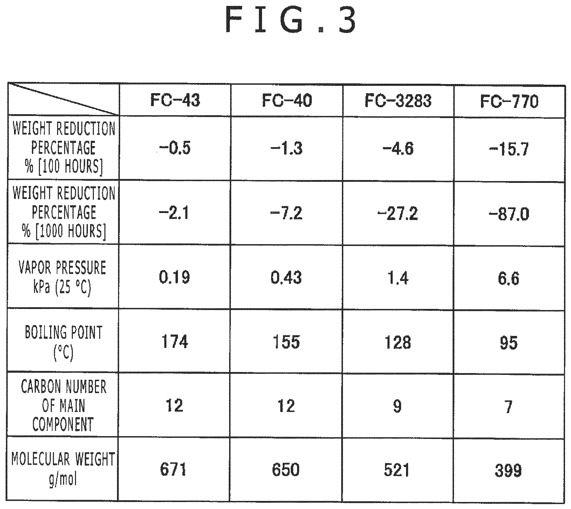

FIG. 3 shows a table on which FC-43, FC-40, FC3283 and FC-770 are compared in weight reduction percentage after the laps of 100 hours, weight reduction percentage after the laps of 1000 hours, vapor pressure, boiling point, main component carbon number, and molecular weight.

Through experiments, it became clear that where the liquid weight reduction percentage after the laps of 100 hours is 1.5 % or less, the cooling liquid is hard to vaporize even in the case that the cooling tank 12 is of the open space being non-airtight. Although it is important to configure the cooling tank 12 as being not sealed in order not to spoil the maintainability, it was grasped that the use of FC-43 or FC-40 as a cooling liquid enables the loss due to vaporization of the first cooling liquid 13 to be reduced greatly.

From the foregoing result, it is understood that the use of Fluorinert FC-43 or FC-40 particularly as the first cooling liquid is very advantageous. However, as mentioned already, according to the present invention, no limitation is of course imposed on choosing for the first cooling liquid 13 either of Fluorinert FC-72, FC-770 or FC-3283 as the cooling liquid having the boiling point T₁ which is the same as the boiling point T₂ of the second refrigerant enclosed in the first heat exchanger referred to later or which is higher than the boiling point T₂ of the second refrigerant.

Incidentally, because Fluorinert FC-43 or FC-40 has a boiling point being 150 °C or higher and has the property of being extremely hard to vaporize, the top board 20 provided at the upper opening of the cooling tank 12 may be attached to the upper opening to be detachable or openable and closable so that the maintenance of the electronic device 100 can be done easily. For example, the top board 20 may be supported to be openable and closable by a hinge portion (not shown) provided at one brim portion of the upper opening of the cooling tank 12. Further, a lateral portion of the cooling tank 12 is provided at a lower portion with an inlet 16 for enabling the first cooling liquid to flow in and is provided at an upper portion with an outlet 18 for enabling the first cooling liquid to flow out. Thus, a configuration is taken so that the electronic device 100 stored in the open space of the cooling tank 12 is immersed in the first cooling liquid 13 circulating in the open space of the cooling tank 12 to be cooled directly.

Referring to FIG. 1, the cooling system 10 according to one embodiment further has a first heat exchanger 22 mechanically held by the top board 20, and the first heat exchanger 22 is immersed in a surface layer portion of the first cooling liquid 13. The method of mechanically holding the first heat exchanger 22 suffices to use, for example, a suspending support member (not shown) secured to the top board 20 but is not limited to this. The first heat exchanger 22 encloses a third refrigerant (not shown) having a boiling point T₃ (T₃ = T₁ or T₃ < T₁) being the same as the boiling point T₁ of the first cooling liquid or being lower than the boiling point T₁ of the first cooling liquid. Here, being "enclosed" means that the third refrigerant does not leak to the outside air but does not means that the third refrigerant is restrained from moving from the first heat exchanger to another component portion (for example, to a second heat exchanger referred to later) or form circulating between the first heat exchanger and another component portion. As the third cooling liquid, like the first cooling liquid, there can preferably be used a hydrofluoroether (HFE) compound known as brand names of 3M Company: "Novec 7000" (boiling point: 34 °C), "Novec 7100" (boiling point: 61 °C), "Novec 7200" (boiling point: 76 °C), and "Novec 7300" (boiling point: 98 °C), but the third cooling liquid is not limited to any of these. However, it is important to choose, as the third refrigerant, a refrigerant having the boiling point T₃ which is the same as the boiling point T₁ of the first cooling liquid 11 or is lower than the boiling point T₁ of the first cooling liquid 11, according the present invention. As one example, where "Novec 7000" (boiling point: 34 °C) is used as the first cooling liquid 11, "Novec 7000" (boiling point: 34 °C) can preferably be used as the third refrigerant. Where "Novec 7100" (boiling point: 61 °C) is used as the first cooling liquid 11, "Novec 7000" (boiling point: 34 °C) or "Novec 7100" (boiling point: 61 °C) can preferably be used as the third refrigerant.

As shown in FIG. 1 and FIG. 4, the cooling system 10 according to the one embodiment is preferable to be further provided with a second heat exchanger 24 placed outside the cooling tank 12. The first exchanger 22 and the second heat exchanger 24 are connected through a first flow passage 26, and thus, a configuration is taken so that the second refrigerant is movable or circulatable between the first exchanger 22 and the second heat exchanger 24 through the first flow passage 26. In order to be immersed in the surface layer portion of the first cooling liquid 13, a heat exchanger of a thin type is preferable to be used as the first heat exchanger and, for example, may be a heat exchanger comprising a pipe formed to be a coil form, to be spiral or to be meandering. However, this does not mean to limit the structure of the heat exchanger (a plate-type heat exchanger, a plate-fin-type heat exchanger or the like). The second heat exchange 24 suffices to be a heat exchanger for cooling the second refrigerant moving from the first heat exchanger 22 to the second heat exchanger 24 and, for example, may be any of various heat exchangers (radiators or chillers) and refrigerators of a circulation type.

Referring to FIG. 4, the outlet 18 and the inlet 16 of the cooling tank 12 are connected through a second flow passage 30, and the second flow passage 30 is provided therein with a pump 40 for moving the first cooling liquid 13 and a third heat exchanger 90 for cooling the first cooling liquid 13. Incidentally, the second flow passage 30 is also provided therein with a flow rate regulating valve 50 and a flowmeter 70 for regulating the flow rate of the first cooling liquid 13 flowing in the second flow passage 30.

The pump 40 is preferable to have the performance capable of moving a liquid being relatively large in kinematic viscosity (the kinematic viscosity at the room temperature 25 °C exceeds 3 cSt). This is because, for example, where Fluorinert FC-43 or FC-40 is used as the first cooling liquid 13, the kinematic viscosity of FC-43 is the degree of 2.5 to 2.8 cSt, and the kinematic viscosity of FC-40 is the degree of 1.8 to 2.2 cSt. The flow rate regulating valve 50 may be one operated manually or one with a regulating mechanism for maintaining the flow rate constant based on a measured value of the flowmeter 70. Additionally, the third heat exchanger 90 may be any of various heat exchangers (radiators or chillers) and refrigerators of a circulation type.

Next, description will be made regarding the operation of the cooling system 10 according to the one embodiment. After the operation of the electronic device 100 is started, the first cooling liquid 13 (for example, Fluorinert FC-43) around the electronic device 100 takes heat away directly or through the heat radiating members 114 from the processors and the peripheral electronic components (not shown) mounted on the processor boards 110, 112 to cool the electronic device as a whole. Because of being immersed in the surface layer portion of the first cooling liquid 13 within the cooling tank 12, the first heat exchanger 22 enclosing the second refrigerant takes heat away from the surface layer portion in the first cooling liquid 13 to take the heat outside the cooling tank 12, the second refrigerant having the boiling point T₂ being the same as the boiling point T₁ of the first cooling liquid 13 or being lower than the boiling point T₁ of the first cooling liquid 13. In this way, a double cooling is carried out which includes the liquid immerse cooling of the whole of the main heating elements and the peripheral electronic components (not shown) by the first cooling liquid 13 within the cooling tank 12 having the open space and the deprivation of heat from the surface layer portion of the liquid immerse refrigerant (the first cooling liquid 13) by the first heat exchanger 22 and thus, it is possible to improve the performance in cooling the electronic device 100.

Further, because the cooling liquid being relatively high in boiling point (for example, Fluorinert FC-43 or FC-40 is 150 °C or higher in boiling point) can be used as the first cooling liquid 13, the first cooling liquid 13 is hard to vaporize, and the cooling tank 12 containing the first cooling liquid 13 can be made as an open space being non-airtight, so that it is not necessary to adopt an airtight or sealed structure which is complicated and expensive. In addition, since the first heat exchanger 22 suffices to be immersed in the surface layer portion of the first cooling liquid 13, the volume occupied by the construction components within the cooling tank 12 is sufficient to be small. Accordingly, it can be realized to simplify and downsize the cooling system. Incidentally, in the present embodiment, even where a cooling liquid whose boiling point T₂ is the same as the boiling point T₁ of the first cooling liquid 13 is used as the second refrigerant used in the first heat exchanger 22, it is of course possible to attain the object of greatly improving the cooling efficiency in the cooling system of the prior art.

In the foregoing, with reference to FIG. 1 through FIG. 4, the cooling system according to the one embodiment has been described taking the example wherein the electronic device of one unit is stored in the cooling tank. This is one that is simplified for describing the important part of the present invention, and the present invention is not limited to the example. It is a matter of course that the present invention is applicable to a high-density cooling system for cooling a plurality of units of electronic devices stored in a cooling tank in a high density. Hereafter, the structure of a high-density cooling system according to the other embodiment of the present invention will be described with reference to FIG. 5 through FIG. 7. Incidentally, the same portions as those in the cooling system shown in FIG. 1 and FIG. 4 will be given the same reference signs and will be omitted from being described in detail.

In the description of the other embodiment, the structure of a high-density cooling system will be described that cools 16 units in total of electronic devices stored in respective storage sections of a cooling tank, each unit including a board 120 mounting a plurality of processor boards 110, 112. Incidentally, this is for the purpose of exemplification. The number of the processor boards and the kind of the processor (CPU or GPU) per board are discretionary, the number of units of the electronic devices in the high-density cooling system is also discretionary, and such number or kind does not limit the configuration of the electronic device in the present invention.

Referring to FIG. 5 through FIG. 7, a cooling system 500 according to the other embodiment of the present invention has a cooling tank 12, and an open space 10a is defined by a bottom wall 12a and side walls 12b of the cooling tank 12. The open space 10a is divided equally into sixteen by the provision of inner partitioning walls 13a, 13b, 13c, 13d, 13e in a length direction and inner partitioning walls 14a, 14b, 14c, 14d, 14e in a width direction in the cooling tank 12, whereby sixteen arrayed storage sections 15aa, 15ab, 15ac, 15ad, 15ba, 15bb, 15bc, 15bd, 15ca, 15cb, 15cc, 15cd, 15da, 15db, 15dc, 15dd (hereafter, occasionally referred to as "storage sections 15aa to 15dd" collectively) are defined. Then, at least one electronic device 100 is stored in each storage section. Within the open space 10a of the cooling tank 12, a first cooling liquid 13 is contained up to a liquid level 19. The storage sections 15aa, 15ab, 15ac, 15ad, 15ba, 15bb, 15bc, 15bd, 15ca, 15cb, 15cc, 15cd, 15da, 15db, 15dc, 15dd are formed at bottom portions with inflow openings 16aa, 16ab, 16ac, 16ad, 16ba, 16bb, 16bc, 16bd, 16ca, 16cb, 16cc, 16cd, 16da, 16db, 16dc, 16dd (hereafter, occasionally referred to as "inflow openings 16aa to 16dd" collectively) for the first cooling liquid 13, respectively.

Further, in the vicinity of the liquid level 19 of the first cooling liquid 13 flowing through the storage sections 15aa to 15dd, there are formed outflow openings 17aa, 17ab, 17ac, 17ad, 17ae, 17ba, 17bb, 17bc, 17bd, 17be, 17ca, 17cb, 17cc, 17cd, 17ce, 17da, 17db, 17dc, 17dd, 17de, 17ea, 17eb, 17ec, 17ed, 17ee (hereafter, occasionally referred to as "outflow openings 17aa to 17ee" collectively).

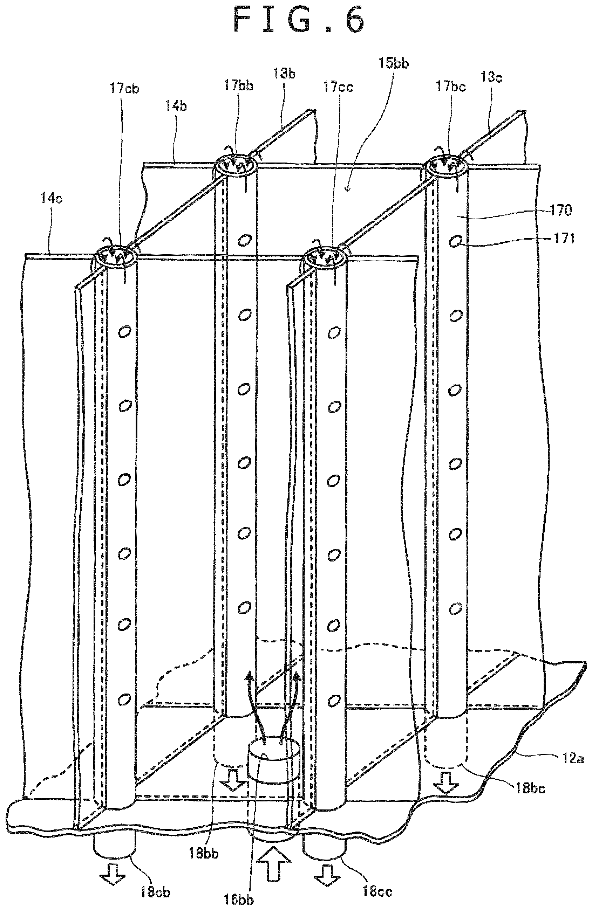

In the cooling system 500 according to the other embodiment, the outflow openings are formed at positions where the plurality of inner partitioning walls defining respective storage sections intersect with one another, or in the vicinities of such positions. For example, referring to FIG. 5, the storage section 15aa is defined by the inner partitioning wall 13a, 13b in the length direction and the inner partitioning wall 14a, 14b in the width direction, and the outflow openings 17aa, 17ba, 17ab, 17bb are formed to be located respectively at an intersection point of the inner partitioning wall 13a and the inner partitioning wall 14a, an intersection point of the inner partitioning wall 13a and the inner partitioning wall 14b, an intersection point of the inner partitioning wall 13b and the inner partitioning wall 14a, and an intersection point of the inner partitioning wall 13b and the inner partitioning wall 14b. Likewise, referring to FIG. 6, the storage section 15bb is defined by the inner partitioning walls 13b, 13c in the length direction and the inner partitioning walls 14b, 14c in the width direction, and the outflow openings 17bb, 17cb, 17bc, 17cc are formed to be located respectively at an intersection point of the inner partitioning wall 13b and the inner partitioning wall 14b, an intersection point of the inner partitioning wall 13b and the inner partitioning wall 14c, an intersection point of the inner partitioning wall 13c and the inner partitioning wall 14b, and an intersection point of the inner partitioning wall 13c and the inner partitioning wall 14c.

In the cooling system 500 according to the other embodiment, the outflow openings are formed at respective one ends of outflow pipes 170 piercing through the bottom wall 12a of the cooling tank 12 and extending to the vicinity of the liquid level 19. For example, referring to FIG. 6, with respect to the storage section 15bb, the outflow openings 17bb, 17cb, 17bc, 17cc are formed at respective one ends of the outflow pipes 170 which are defined by the inner partitioning walls 13b, 13c in the length direction and the inner partitioning walls 14b, 14c in the width direction and which are located respectively at an intersection point of the inner partitioning wall 13b and the inner partitioning wall 14b, an intersection point of the inner partitioning wall 13b and the inner partitioning wall 14c, an intersection point of the inner partitioning wall 13c and the inner partitioning wall 14b, and an intersection point of the inner partitioning wall 13c and the inner partitioning wall 14c. Incidentally, respective other ends of the outflow pipes are formed respectively with bottom openings 18aa, 18ab, 18ac, 18ad, 18ae, 18ba, 18bb, 18bc, 18bd, 18be, 18ca, 18cb, 18cc, 18cd, 18ce, 18da, 18db, 18dc, 18dd, 18de, 18ea, 18eb, 18ec, 18ed, 18ee (hereafter, occasionally referred to as "bottom openings 18aa to 18ee" collectively).

Where the outflow openings are defined at the positions where the plurality of inner partitioning walls defining the respective storage sections intersect with one another, an advantage is obtained in that the outflow openings provided for the respective storage sections can be secured to be distributed to four corners of each storage section. For example, at the storage section 15bb, the outflow pipes 170 arranged at the four corners of the section define the outflow openings 17bb, 17bc, 17cb and 17cc. Incidentally, where the outflow openings are defined like this, one outflow opening can become an outflow opening common to the plurality of storage sections. For example, the outflow opening 17bb is a part of the outflow openings for the storage section 15aa and at the same time, is also a part of the outflow openings for the storage sections 15ab, 15ba and 15bb. The same applies also to the outflow openings 17bc, 17cb and 17cc. However, the positions and the number of the outflow pipes provided for each storage section are discretionary, and one or plural outflow pipes may, of course, be provided in the vicinities of the positions where the plurality of inner partitioning walls defining each storage section intersect with one another. Further, the outflow pipes are not required to be integrated with the inner partitioning walls and may be pipes arranged apart from the inner partitioning walls.

Further, as shown in FIG. 6, each outflow pipe 170 may be formed with one or more small holes 171 in the longitudinal direction of the outflow pipe 170. These small holes 171 accelerate the flow of the first cooling liquid 13 remaining in the midway of the storage section in the depth direction. On the other hand, each of the inflow openings 16aa to 16dd is not required to be a cylindrical opening, as illustrated. For example, a header with a plurality of nozzles may be connected to one end of a cylinder to define the inflow opening by the plurality of nozzles.

In each of the storage sections 15aa to 15dd, an electronic device 100 is stored and immersed in the first cooling liquid 13. The electronic device 100 is the same as the electronic device in the preceding one embodiment and will be omitted herein from being described in detail.

In the cooling tank 12, the first cooling liquid 13 of the quantity sufficient to immerse the whole of the electronic device 100 is contained up to the liquid level 19. The first cooling liquid 13 is the same as the first cooling liquid in the preceding one embodiment and will be omitted herein from being described in detail.

The cooling tank 12 is provided with an inlet 16 for distributing the first cooling liquid 13 through a distribution pipe (not shown) toward the inflow openings 16aa to 16dd provided at the respective storage sections 15aa to 15dd and an outlet 18 for collecting through a collecting pipe (not shown) the first cooling liquids 13 passing through the outflow openings 17aa to 17ee of the respective storage sections 15aa to 15dd.

In order that the first cooling liquid 13 cooled to a predetermined temperature continuously goes through the interiors of the respective storage sections 15aa to 15dd whereby the electronic devices 100 stored in the respective storage sections 15aa to 15dd can be kept at a predetermined temperature or lower during the operations, it is preferable to configure a second flow passage that by a heat exchanger, cools the first cooling liquid 13 coming out of the outlet 18 of the cooling tank 12 to return the cooled cooling liquid to the inlet 16 of the cooling tank 12. One example of such a flow passage and the attendant facility has already been described in detail with reference to FIG. 4, and thus, the description of those will be omitted here.

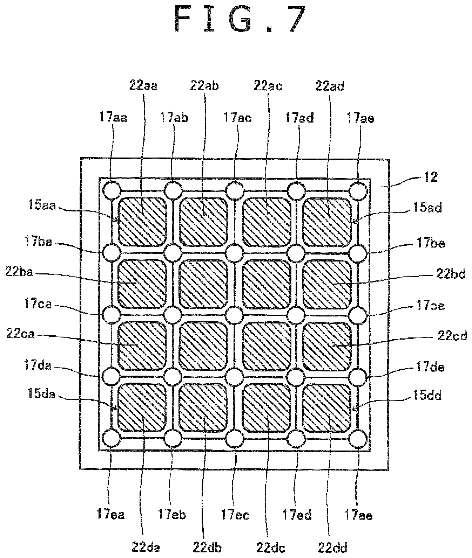

Referring to FIG. 7, the cooling system 500 according to the other embodiment has distributed first heat exchangers 22aa, 22ab, 22ac, 22ad, 22ba, 22bb, 22bc, 22bd, 22ca, 22cb, 22cc, 22cd, 22da, 22db, 2dc and 22dd (hereafter, occasionally referred to as "distributed first heat exchangers 22aa to 22dd" collectively) which each enclose a second refrigerant having a boiling point T₂ (T₁ = T₂ or T₁ > T₂) being the same as the boiling point T₁ of the first cooling liquid 13 or being lower than the boiling point T₁ of the first cooling liquid 13. Each of the distributed first heat exchangers 22aa to 22dd is immersed in the surface layer portion of the first cooling liquid 13 in each of the storage sections 15aa to 15dd. Like the first heat exchanger in the one embodiment, each of the distributed first heat exchangers 22aa to 22dd may be mechanically held by a top board (not show) . Further, like the example shown in FIG. 1, each of the distributed first heat exchangers 22aa to 22dd may be connected to a second heat exchanger disposed outside the cooling tank 12 through a first flow passage (not shown) . This connection may take any of a method of providing second heat exchangers of the same number as the distributed first heat exchangers 22aa to 22dd to make connections therebetween individually, a method of dividing the distributed first heat exchangers 22aa to 22dd into plural groups (e.g., four) each comprising a number (e.g. four) of heat exchangers and of providing second heat exchangers of the number corresponding to the groups to make connections therebetween individually, and a method of connecting one second heat exchanger to the whole of the distributed first heat exchangers 22aa to 22dd.

Next, description will be made regarding the operation of the cooling system 500 according to the other embodiment. The first cooling liquid 13 entering at the inlet 16 is distributed through a distribution pipe not shown toward the inflow openings 16aa to 16dd formed at the bottom portions of the storage sections 15aa to 15dd. The first cooling liquid 13 is forced upward from the inflow openings 16aa to 16dd and takes heat away directly or through the heat radiating members 114 from the processors and the peripheral electronic components (not shown) on the processor boards 110, 112 mounted on the board 120 of the electronic device 100 to cool the electronic device as a whole. For example, the first cooling liquid 13, when forced upward from the inflow opening 16bb, goes up toward the liquid level 19 while taking heat away from the surfaces of the processors and the peripheral electronic components (not shown) on the processor boards 110, 112 and further, moves toward the outflow openings 17bb, 17bc, 17cb, 17cc. In this case, each volume of the storage sections 15aa to 15dd is small to be about 1/16 of the volume of the open space 10a of the cooling tank 12, and the electronic device 100 stored therein is also small to be about 1/4 wide of the width of the cooling tank 12. Thus, the cooling efficiency of the electronic device 100 by the first cooling liquid 13 is extremely excellent, and the first cooling fluid 13 can effectively be prevented from remaining around the electronic device 100.

Additionally, at each of the storage sections 15aa to 15dd, each of the distributed first heat exchangers 22aa to 22dd takes heat away from the surface layer portion of the first cooling liquid 13 to take the heat outside the cooling tank 12. In this way, a double cooling is performed which includes the liquid immerse cooling of the whole of the main heating elements and the peripheral electronic components (not shown) by the first cooling liquid 13 within the cooling tank 12 having the open space and the deprivation of heat from the surface layer portion of the liquid immerse refrigerant (the first cooling liquid 13) by the distributed first heat exchangers 22aa to 22dd. The first cooling liquid 13 goes through the outflow openings 17aa to 17ee located in the vicinity of the surface level 19 in the cooling tank 12, goes down the outflow pipes 170 to go through the bottom openings 18aa to 18ee, and is collected to the outlet 18 through the collecting pipe (not shown).

Although in the foregoing the other embodiment, description has been made of the example wherein the inflow opening is formed at the bottom portion of each storage section, the inflow opening may be formed at a lateral surface of each storage section.

According to the high-density cooling system according to the foregoing the other embodiment, an electronic device of the width (for example, about 1/2, 1/3 or 1/4) being smaller than that in the prior art is stored in the storage section of the volume being about 1/4 or the volume being smaller than about 1/4 of the volume of the open space of the cooling tank (for example, about 1/9 (in the case of the division of 3 in length by 3 in width), 1/12 (in the case of the division of 3 in length by 4 in width), or 1/16 (in the case of the division of 4 in length by 4 in width) of the open space volume), and the cooling liquid is made to flow individually, so that it becomes possible to cool the plurality of electronic devices individually and efficiently. In other words, in the high-density cooling system according to the foregoing the other embodiment, since the warmed cooling liquid can be made to flow out also from center portions of the cooling tank, it can be avoided that the cooling liquid stays at around the center of the cooling tank to cause the cooling performance to differ in dependence on the storage positions of the electronic devices as is the case in the prior art wherein warmed cooling liquid is made to flow out from the lateral surface of the cooling tank. Accordingly, the cooling performance of the plurality of electronic devices can be improved and can be stabilized by being prevented from being varied in cooling performance. Further, since the electronic devices stored in the storage sections can be reduced in dimension, it is possible to improve the handling and maintainability of the electronic devices.

Although in the foregoing one embodiment and the foregoing the other embodiment, a configuration is taken so that the first cooling liquid 13 can circulate within the cooling tank 12 since the same has the inlet 16 and the outlet 18 for the first cooling liquid 13, the inlet and the outlet may be omitted. This is because even in a cooling system without the inlet and the outlet, the double cooling can be performed which includes the liquid immerse cooling of the whole of the main heating elements and the peripheral electronic components (not shown) by the first cooling liquid 13 within the cooling tank 12 having the open space and the deprivation of heat from the surface layer portion of the liquid immerse cooling refrigerant (the first cooling liquid 13) by the first heat exchanger 22 or the distributed first heat exchangers 22aa to 22dd. Therefore, the cooling system according to the one embodiment may be altered to a configuration wherein like the cooling tank in the cooling system shown in the other embodiment, the open space is divided by the provision of a plurality of inner partitioning walls within the cooling tank to define a plurality of arrayed storage sections while inflow openings and outflow openings are omitted.

In the foregoing one embodiment and the foregoing the other embodiment, the processor mounted on the board of the electronic device 100 may include either or both of CPU and GPU and further may include a high speed memory, a chip set, a network unit, a PCI express bus, a bus switching unit, an SSD, and power units (ac-dc converter, dc-dc voltage converter and the like). Further, the electronic device 100 may be an electronic device like a server including a blade server, a router, a storage device such as an SSD or the like. However, as mentioned already, in the other embodiment, the electronic device may, of course, be of a smaller width (for example, about 1/2, 1/3 or 1/4) than that of those conventional in the prior art.

### Industrial Applicability

The present invention is widely applicable to cooling systems for cooling electronic devices efficiently.

### Reference Signs List

10, 500: Cooling system
100: Electronic device
110: Processor board (with CPU mounted)
112: Processor board (with GPU mounted)
114: Heat radiating member (radiating fin)
120: Board
10a: Open space
12: Cooling tank
12a: Bottom wall
12b: Side wall
13: first cooling liquid
13a, 13b, 13c, 13d, 13e: Inner partitioning wall
14a, 14b, 14c, 14d, 14e: Inner partitioning wall
15aa, 15ab, 15ac, 15ad, 15ba, 15bb, 15bc, 15bd, 15ca, 15cb, 15cc, 15cd, 15da, 15db, 15dc, 15dd: storage section
16: Inlet
16aa, 16ab, 16ac, 16ad, 16ba, 16bb, 16bc, 16bd, 16ca, 16cb, 16cc, 16cd, 16da, 16db, 16dc, 16dd: inflow opening
17aa, 17ab, 17ac, 17ad, 17ae, 17ba, 17bb, 17bc, 17bd, 17be, 17ca, 17cb, 17cc, 17cd, 17ce, 17da, 17db, 17dc, 17dd, 17de, 17ea, 17eb, 17ec, 17ed, 17ee: outflow opening
170: Outflow pipe
171: Small hole
18: Outlet
18aa, 18ab, 18ac, 18ad, 18ae, 18ba, 18bb, 18bc, 18bd, 18be, 18ca, 18cb, 18cc, 18cd, 18ce, 18da, 18db, 18dc, 18dd, 18de, 18ea, 18eb, 18ec, 18ed, 18ee: Bottom opening
19: Liquid level
20: Top board
22: First heat exchanger
22aa, 22ab, 22ac, 22ad, 22ba, 22bb, 22bc, 22bd, 22ca, 22cb, 22cc, 22cd, 22da, 22db, 2dc, 22dd: Distributed first heat exchanger
24: Second heat exchanger
26: First flow passage
30: Second flow passage
40: pump
50: flow rate regulating valve
70: Flowmeter
90: Third heat exchanger

## Claims

1. A cooling system for directly cooling an electronic device through immersion in a cooling liquid, the cooling system comprising:
a cooling tank having an open space defined by a bottom wall and side walls and containing a first cooling liquid having a boiling point T₁, wherein at least one electronic device having at least one heating element is immersed in the first cooling liquid to be cooled directly; and
a first heat exchanger enclosing a second refrigerant having a boiling point T₂ (T₂ = T₁ or T₂ < T₁) being the same as the boiling point T₁ of the first cooling liquid or being lower than the boiling point T₁ of the first cooling liquid and immersed in a surface layer portion of the first cooling liquid in the cooling tank.

2. The cooling system according to Claim 1, wherein:
the first cooling liquid includes perfluoride as a main component; and
the weight reduction percentage of the liquid after a lapse of 100 hours is 1.5 % or less when 10 milliliter of the liquid is contained in a 10-milliliter graduated cylinder (opening diameter 11.5 mm) to be subjected to spontaneous evaporation under an ordinary environment at a room temperature of 25 °C.

3. The cooling system according to Claim 2, wherein the vapor pressure of the first cooling liquid at the room temperature of 25 °C is 1.0kPa or under.

4. The cooling system according to Claim 1 or 2, wherein:
the boiling point of the first cooling liquid is 150 °C or higher; and
the boiling point of the second refrigerant is 50 °C or lower.

5. The cooling system according to Claim 3, wherein the second refrigerant includes a fluorocarbon compound as a main component.

6. The cooling system according to Claim 1, further comprising:
a second heat exchanger disposed outside the cooling tank for cooling the second refrigerant; and
wherein the first heat exchanger and the second heat exchanger are connected through a first flow passage.

7. The cooling system according to Claim 1, wherein:
the cooling tank includes a top board attached to an upper opening of the cooling tank to be detachable or to be openable and closable; and
the top board holds the first heat exchanger.

8. The cooling system according to Claim 1, wherein:
the cooling tank has an inlet and an outlet for the first cooling liquid;
the inlet and the outlet are connected through a second flow passage being outside the cooling tank; and
the flow passage is provided with at least one pump for moving the first cooling liquid and a third heat exchanger for cooling the first cooling liquid.

9. A cooling system for directly cooling a plurality of electronic devices through immersion in a cooling liquid, the system comprising:
a cooling tank having an open space defined by a bottom wall and side walls and containing a first cooling liquid having a boiling point T₁;
a plurality of arrayed storage sections defined by a plurality of inner partitioning walls provided within the cooling tank to divide the open space for storing at least one electronic device in each storage section; and
an inflow opening and an outflow opening for the first cooling liquid that are formed at each of the plurality of storage sections;
wherein the inflow opening is formed at a bottom portion or a lateral surface of each storage section while the outflow opening is formed in the vicinity of a liquid level of the cooling liquid flowing through each storage section;
the cooling system further comprising:
a first heat exchanger enclosing a second refrigerant having a boiling point T₂ (T₂ = T₁ or T₂ < T₁) being the same as the boiling point T₁ of the first cooling liquid or being lower than the boiling point T₁ of the first cooling liquid;
wherein the first heat exchanger is immersed in a surface layer portion of the first cooling liquid within each storage section.
